# EUROPEAN PATENT APPLICATION

(11) **EP 4 579 296 A1**
(43) Date of publication of application: **02.07.2025**
(21) Application number: 23220851.2
(22) Date of filing: 29.12.2023
(51) Int. Cl.: G02B 6/122, H01L 23/66, H01Q 1/22

(54) **TERAHERTZ INTEGRATED CIRCUIT DEVICE AND METHOD OF MANUFACTURING THEREOF**

(71) Applicant: Université catholique de Louvain, 1348 Louvain-la-Neuve (BE)
(72) Inventor: LEDERER, Dimitri, 1348 Louvain-la-Neuve (BE); FRANCIS, Laurent, 1348 Louvain-la-Neuve (BE); RASKIN, Jean-Pierre, 1348 Louvain-la-Neuve (BE)
(74) Representative: den Braber, Gérard Paul

(57) **Abstract**

An integrated circuit device capable of operating at a frequency in a range between 0.1 THz and 10 THz has the following features. The integrated circuit device comprises a substrate (105) comprising low-resistivity semiconductor material (106). The low-resistivity semiconductor material (106) has a resistivity that is nominally lower than 0.1 Ohm.cm. A channel of porous semiconductor material (107) is comprised in the low-resistivity semiconductor material (106). The porous semiconductor material (107) has a resistivity that is higher than 100 Ohm.cm. The channel of porous semiconductor material (107) constitutes a signal path (116) within the integrated circuit device for a signal having a frequency in the range between 0.1 THz and 10 THz.

## Description

### FIELD OF THE INVENTION

An aspect of the invention relates to an integrated circuit device capable of operating at a frequency in a range between 0.1 terahertz (THz) and 10 THz. Such integrated circuit devices may be used in, for example, imaging applications, chemical analysis applications, and communication applications. Other aspects of the invention relate to a method of manufacturing an integrated circuit device capable of operating at a frequency in a range between 0.1 THz and 10 THz.

### BACKGROUND ART

Terahertz (THz) signals may be defined as signals having a frequency in a range between 0.1 THz and 10 THz, which is referred to hereinafter as the terahertz range. Terahertz signals have interesting properties, which makes these signals particularly suited for various applications. For example, a wide variety of molecules, in particular organic molecules, exhibit relatively strong signal absorption in the terahertz range. Moreover, different molecules have different absorption characteristics in the terahertz range. In a manner of speaking, each may have a unique absorption fingerprint. Thus, a chemical analysis may be made by detecting one or more molecules using terahertz signals.

Terahertz signals may also advantageously be used for imaging objects for the purpose of, for example, quality control, security screening, or medical analysis. Terahertz signals are generally non-ionizing, which may make that these are more suitable than X-rays for imaging objects. For example, imaging a living body using terahertz signals may be safer than using X-rays. Moreover, cancerous cells and healthy cells have different absorption characteristics in the terahertz range. Imaging body tissue using terahertz signals may thus allow detection of cancerous cells in the body tissue.

Terahertz signals may also advantageously be used for communication. A terahertz signal may constitute a carrier that can be modulated with significantly higher frequencies than a gigahertz signal. This allows achieving high speed data rates beyond what is achievable with, for example, communication based on so-called 5G technology. Moreover, high speed data rates can be achieved without this requiring complex modulation techniques. However, terahertz signals propagating through ambient air are relatively strongly attenuated. It is therefore contemplated that communication using terahertz signals will generally be over relatively short ranges. This may be advantageous from a security point of view.

There are technical challenges in enabling more widespread use of terahertz signal in applications as those discussed hereinbefore, as well as in other applications. An important challenge is the development and manufacture of integrated circuit devices capable of operating at a frequency in the terahertz range. Such an integrated circuit device may need to generate, detect, or process a terahertz signal, or carry out a combination of these operations. A further challenge is implementing these integrated circuit devices on a semiconductor substrate, preferably a silicon substrate, based on existing technology or on upcoming advancements thereof.

An integrated circuit device capable of operating at a frequency in the terahertz range will generally need to comprise a signal path via which a terahertz signal can propagate from one point in the integrated circuit device to another point. Therefore, one of the challenges to be met is implementing a terahertz signal path in an integrated circuit device. A further challenge is to do so in a way that is cost-effective yet allows proper propagation through the signal path with relatively low signal loss and low signal distortion.

An integrated signal path for terahertz signals may be manufactured on the basis of two silicon wafers. One of the two silicon wafers may be referred to as support wafer. The other wafer may be referred to as high-resistivity wafer because this wafer needs to have a relatively high resistivity. A metal layer is deposited on a surface of the support wafer. The high-resistivity wafer is bonded to the support wafer so that the metal layer is sandwiched between the two silicon wafers.

The high-resistivity wafer is etched to form two parallel grooves therein that extend to the metal layer that has been deposited on the support wafer. This produces a bar of high-resistivity silicon between the two parallel grooves. The bar of high-resistivity silicon has a top surface and a bottom surface, which rests on the metal layer that has been deposited on the support wafer. The bar of high-resistivity silicon further has two side surfaces, one of which interfaces with one of the two parallel grooves, the other side surface interfacing with the other groove.

Metal is deposited on the high-resistivity wafer that has been etched, making that the metal covers the top surface of the bar of high-resistivity silicon as well as its two side surfaces. The bar of high-resistivity silicon is then surrounded by metal. The metal surrounding the bar of high-resistivity silicon may constitute a signal path for terahertz signals, which is in the form of a waveguide, more specifically, an integrated waveguide.

Although the integrated waveguide manufactured as described hereinbefore may allow proper propagation of terahertz signals, there are several drawbacks. Two silicon wafers need to be provided, the support wafer and the high-resistivity wafer, and these need to be bonded. Moreover, the high-resistivity wafer needs to have a resistivity of at least 3 kiloOhm.cm to ensure that signal loss in the integrated waveguide is acceptable. Such high-resistivity wafers are relatively expensive. Another drawback concerns etching the high-resistivity wafer to form the aforementioned two parallel grooves therein. This is a relatively lengthy process because a relatively large quantity of silicon needs to be removed. Moreover, this generally requires a specific technique referred to as deep reactive ion etching, designated by the acronym DRIE, which is relatively costly. All in all, manufacturing the integrated waveguide as described hereinbefore is relatively complex and expensive, making an integrated circuit device comprising such a waveguide will be relatively expensive.

Patent publication WO9637911A1 describes a structure with porous silicon on a substrate surface. In an area of the porous silicon, an optical waveguide is formed by a low-porous core adjacent to higher-porous areas, which surround the low-porous core.

### SUMMARY OF THE INVENTION

There is a need for a technique that offers an improvement for integrated circuit devices capable of operating at a frequency in the terahertz range, the improvement concerning at least one of the following aspects: easier manufacturing and lower cost of these devices.

An aspect of the invention, which is defined in claim 1, relates to an integrated circuit device capable of operating at a frequency in a range between 0.1 THz and 10 THz, the integrated circuit device comprising:
- a substrate comprising low resistivity semiconductor material, the low resistivity semiconductor material having a resistivity that is nominally lower than 0.1 Ohm.cm; and
- a channel of porous semiconductor material comprised in the low resistivity semiconductor material, the porous semiconductor material having a resistivity that is higher than 100 Ohm.cm, the channel of porous semiconductor material constituting a signal path within the integrated circuit device for a signal having a frequency in the range between 0.1 THz and 10 THz.

A further aspect of the invention, which is defined in claim 15, relates to a method of manufacturing an integrated circuit device capable of operating at a frequency in a range between 0.1 THz and 10 THz, the method comprising:
- providing a substrate comprising low resistivity semiconductor material, the low resistivity semiconductor material having a resistivity that is nominally lower than 0.1 Ohm.cm; and
- making the low-resistivity semiconductor material locally porous to form a channel of porous semiconductor material that is comprised in the low-resistivity semiconductor material, wherein the low-resistivity semiconductor material is locally made porous to an extent that the porous semiconductor material has a resistivity that is higher than 100 Ohm.cm , the channel of porous semiconductor material constituting a signal path within the integrated circuit device for a signal having a frequency in the range between 0.1 THz and 10 THz.

In each of these aspects, a terahertz signal path may be formed in an integrated circuit device in a relatively simple way, allowing the integrated circuit device to be relatively inexpensive. A single substrate, and thus a single wafer, is sufficient to form an integrated terahertz signal path whereas, in the prior art technique described hereinbefore, two wafers are required and these need to be bonded. In addition, a substrate comprising low-resistivity semiconductor material, which is used in the aforementioned aspects of the invention, may be less expensive than a high-resistivity wafer, which is required in the prior art technique. What is more, making the low-resistivity semiconductor material locally porous will generally be easier and less time consuming than etching relatively deep grooves in the high-resistivity wafer. Also, the substrate may still have a substantially planar top surface once the terahertz signal path has been formed. This facilitates further processing of the substrate to form, for example, other electrical components and circuits. Each of the aforementioned factors may thus contribute to an improvement in at least one of the following aspects: easier manufacturing and lower cost of integrated circuit devices capable of operating at a frequency in the terahertz range.

For the purpose of illustration, some embodiments of the invention are described in detail with reference to accompanying drawings. In this description, additional features will be presented, some of which are defined in the dependent claims, and advantages will be apparent.

### BRIEF DESCRIPTION OF THE DRAWINGS

FIG. 1 is a flow chart diagram of an exemplary method of manufacturing an integrated circuit device capable of operating at a frequency in the terahertz range.
FIG. 2 is a schematic top view of a first exemplary integrated circuit device capable of capable of operating at a frequency in the terahertz range.
FIG. 3 is a schematic top view of a second exemplary integrated circuit device capable of operating at a frequency in the terahertz range.
FIG. 4 is a schematic top view of a third exemplary integrated circuit device capable of capable of operating at a frequency in the terahertz range.
FIG. 5 is a schematic cross-sectional view of a first exemplary signal path in the first exemplary integrated circuit device.
FIG. 6 is a schematic cross-sectional view of a second exemplary signal path in the first exemplary integrated circuit device.
FIG. 7 is a schematic cross-sectional view of a third exemplary signal path in the first exemplary integrated circuit device.
FIG. 8 is a schematic cross-sectional view of a fourth exemplary signal path in the first exemplary integrated circuit device.
FIG. 9 is a graph in which signal loss in the first exemplary signal path is plotted as a function of signal frequency for different resistivities that a semiconductor substrate in which the first exemplary signal path is embedded may have.
FIG. 10 is a graph in which signal loss in the first exemplary signal path is plotted as a function of signal frequency for different radiuses of rounded corners that the first exemplary signal path may have within the semiconductor substrate.
FIG. 11 is a vertically enlarged slice from the graph of FIG. 10 representing the signal loss on a finer scale.

### DESCRIPTION OF SOME EMBODIMENTS

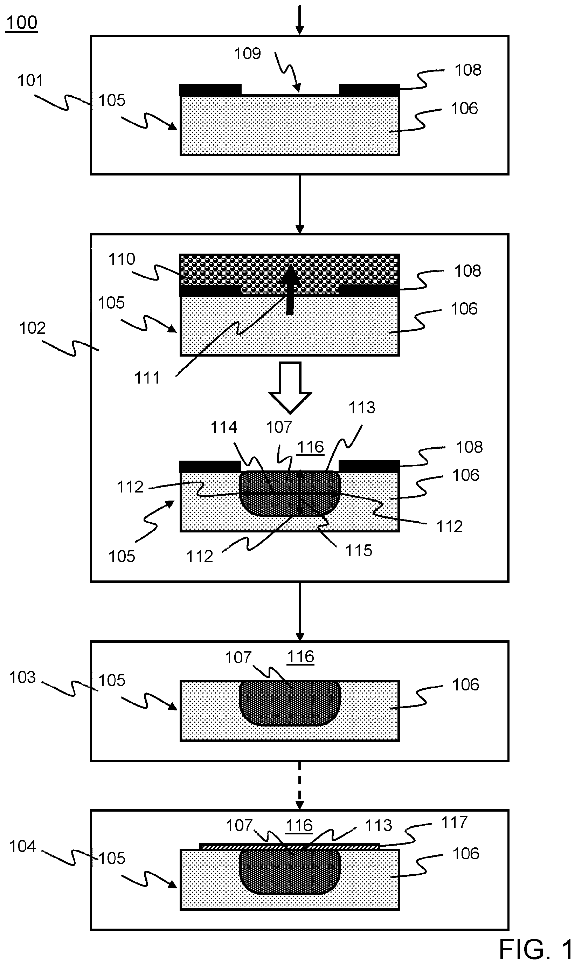

FIG. 1 schematically illustrates an exemplary method 100 of manufacturing an integrated circuit device capable of operating at a frequency in the terahertz range. FIG. 1 provides a flow chart diagram of this manufacturing method 100, which comprises several steps 101-104. The manufacturing method 100 is applied to a substrate 105 comprising low-resistivity semiconductor material 106. The low-resistivity semiconductor material 106 may have a resistivity that is nominally lower than 0.1 Ohm.cm, or even lower than 0.01 Ohm.cm, or yet even lower than 0.001 Ohm.cm. In principle, it holds that the lower the resistivity is, the better certain components in the integrated circuit device will perform. This aspect will be discussed further hereinafter. The low-resistivity semiconductor material 106 may comprise silicon, which will be taken as an example, although the low-resistivity semiconductor material 106 may comprise another type of semiconductor material. For ease of reading, the low-resistivity semiconductor material 106 will be referred to hereinafter as low-resistivity silicon 106.

In the manufacturing method 100 illustrated in FIG. 1, the low-resistivity silicon 106 is locally made porous to form a channel of porous silicon 107 therein. The porous silicon 107 has a resistivity that is several magnitudes higher than that of the low-resistivity silicon 106 bordering the porous silicon 107. The porous silicon 107 may have a resistivity higher than, for example, 100 Ohm.cm, or even higher than 1 kiloOhm.cm, or yet even higher than 10 kiloOhm.cm. In the manufacturing method 100, the channel of porous silicon 107 is formed in two steps 101, 102, which are described in greater detail here.

In a mask deposition step 101, a mask 108 is formed on a top surface of the substrate 105. To that end, a lithographic technique may be used. The mask 108 covers the low-resistivity silicon 106 in the substrate 105. The mask 108 comprises a strip-shaped opening 109, which defines an exposed zone on the top surface of the substrate 105. The mask 108 may comprise at least one further strip-shaped opening, which is not represented in FIG. 1 for the sake of simplicity. The mask 108 is relatively chemically resistant. To that end, the mask 108 may comprise, for example, a dielectric material, such as, for example, silicon oxide, silicon nitride, or another suitable dielectric material. Alternatively, or additionally, the mask 108 may comprise a metal, such as, for example, aluminum, or an alloy.

In an electrochemical treatment step 102, the substrate 105 is brought into contact with a chemically reactive substance 110 while an electrical current 111 is applied to the substrate 105. Specifically, the chemically reactive substance 110 contacts the exposed zone on the top surface of the substrate 105. The electrical current 111 flows from the substrate 105 into the chemically reactive substance 110 passing through the strip-shaped opening 109 in the mask 108. An electrochemical reaction occurs in the substrate 105, creating pores in the low-resistivity silicon 106. This creation of pores starts at the exposed zone and propagates inwardly towards a bottom surface of the substrate 105. The creation of pores transforms the low-resistivity silicon 106 into high-resistivity porous silicon. That is, the formation of pores significantly increases the resistivity, which is a desired effect, as will become apparent hereinafter.

At the end of the electrochemical treatment step 102, the channel of porous silicon 107 has been formed. The channel of porous silicon 107 may have a cross-sectional shape that comprises at least one curved portion. This will generally be the case if the channel of porous silicon 107 is formed as discussed hereinbefore in the electrochemical treatment step 102. Various possible cross-sectional shapes will be discussed hereinafter. The channel of porous silicon 107 that has been formed comprises an embedded interfacing surface 112 where the porous silicon 107 interfaces with the low-resistivity silicon 106. The channel further comprises a top interfacing surface 113 where the porous silicon 107 interfaces with another medium, which may be ambient air at this stage of the manufacturing method 100.

The channel of porous silicon 107 may have a width 114 between 10 µm and 2 mm. More specifically, the width 114 may be between 20 µm and 1 mm, or even more specifically, between 50 µm and 500 µm. The width 114 may be defined as the greatest distance between two opposite points on the embedded interfacing surface 112 along a line parallel to the top surface of the substrate 105 and perpendicular to a longitudinal axis of the channel. The channel porous silicon 107 may have a depth 115 between 5 µm and 500 µm. More specifically, the depth 115 may be between 10 µm and 250 µm, or even more specifically, between 20 µm and 100 µm. The depth 115 may be defined as the greatest distance in the channel from the top interfacing surface 113 of the substrate 105 to the embedded interfacing surface 112, or another interfacing surface, along a line perpendicular to the top surface and perpendicular to the longitudinal axis of the channel.

The channel of porous silicon 107 within the low-resistivity silicon 106, may constitute a signal path 116 for a terahertz signal, which is a signal having a frequency in the range between 0.1 THz and 10 THz as mentioned hereinbefore. This is because the embedded interfacing surface 112 and the top interfacing surface 113 may confine the terahertz signal within the channel of porous silicon 107. Specifically, the embedded interfacing surface 112 may be regarded as an electrically conductive boundary, which partially encloses the porous silicon 107. The porous silicon 107 is a medium of relatively low dielectric loss through which the terahertz signal may propagate. The top interfacing surface 113 of the channel may further ensure that the terahertz signal is confined within the channel of porous silicon 107. At the end of the electrochemical treatment step 102, the porous silicon 107 may interface with ambient air at the top interfacing surface 113 of the channel. A contrast between the permittivity of the porous silicon 107 and that of the ambient air may ensure that the terahertz signal is confined in the channel of porous silicon 107 to a sufficient degree.

In a mask removal step 103, the mask 108 that has been formed on the top substrate 105, which may be still present at the end of the electrochemical treatment step 102, is removed. The mask 108 may be removed by means of, for example, a chemical treatment or another type of treatment, or a combination of treatments, which may be applied simultaneously or consecutively. Once the mask 108 has been removed the top surface of the substrate 105 is substantially planar again.

In an additional step 104, which is optional, an electrically conductive structure 117 is deposited on the top surface of the substrate 105. The electrically conductive structure 117 may cover the channel of porous silicon 107 in width direction over at least a portion of the channel in length direction. That is, the electrically conductive structure 117 may entirely cover the channel of porous silicon 107 or may cover only a longitudinal section thereof. This will be discussed in greater detail hereinafter. In an area where the electrically conductive structure 117 covers the channel of porous silicon 107, the porous silicon 107 interfaces with the electrically conductive structure 117 at the top interfacing surface 113 of the channel. This ensures a relatively strong confinement of a terahertz signal in the channel of porous silicon 107.

The electrically conductive structure 117 may comprise metal, such as, for example, aluminum or another suitable metal, which may be commonly used in semiconductor manufacturing. The electrically conductive structure 117 may be, for example, a single metal layer. Alternatively, the electrically conductive structure 117 may be a composite structure, which may comprise a dielectric material. For example, the electrically conductive structure 117 may comprise multiple layers including a dielectric layer that is in between the top interfacing surface 113 of the channel and a metal layer in the electrically conductive structure 117.

The manufacturing method 100 discussed here may comprise further processing steps, which are not represented in FIG. 1 for the sake of simplicity. For example, at least one electrical circuit may be formed in the substrate 105, or on the substrate 105, or both, in one or more further processing steps. Such an electrical circuit may be an active circuit, which includes at least one active device. Accordingly, a complete system operating in the terahertz range may be formed in the integrated circuit device by further processing the substrate 105. This further processing is facilitated by the top surface of the substrate 105 being substantially planar once the signal path 116 based on porous silicon 107 has been formed as described hereinbefore, or in an analogous manner.

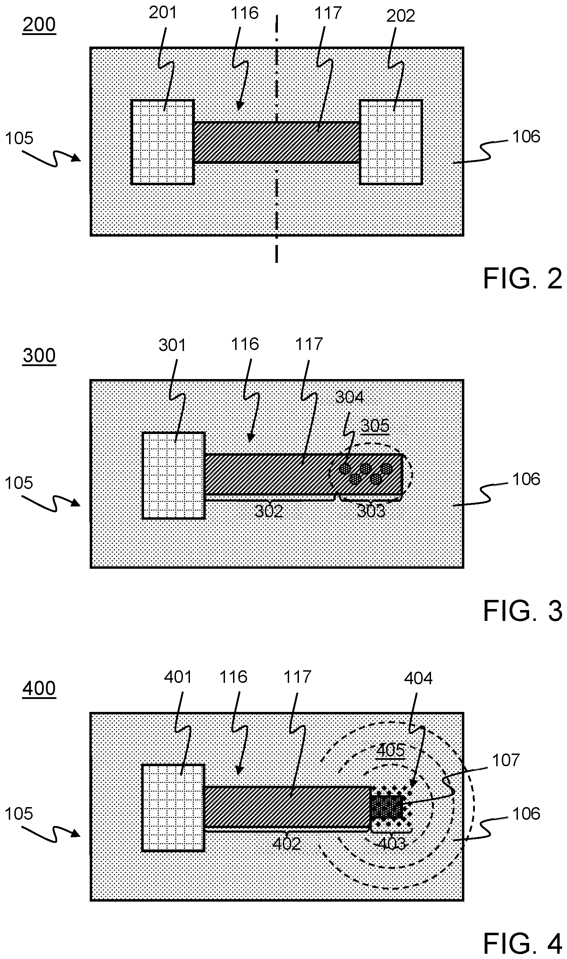

FIG. 2 schematically illustrates a first exemplary integrated circuit device 200 capable of operating at a frequency in the terahertz range. FIG. 2 provides a schematic top view of the first exemplary integrated circuit device 200. The first exemplary integrated circuit device 200 may be manufactured according to the method described hereinbefore with reference to FIG. 1, wherein the additional step 104 has been carried out. Like elements are therefore denoted by like references.

The first exemplary integrated circuit device 200 comprises two electrical circuits 201, 202. The two electrical circuits 201, 202 are coupled with each other by the signal path 116 formed by the channel of porous silicon 107 within the low-resistivity silicon 106 as illustrated in FIG. 1. The channel of porous silicon 107 thus has a length corresponding to a distance between the two electrical circuits 201, 202 on the substrate 105. Since the additional step 104 has been carried out, the electrically conductive structure 117 covers the channel of porous silicon 107. The electrically conductive structure 117 is visible in the schematic top view provided by FIG. 2.

The two electrical circuits 201, 202 may each comprise a coupling structure adapted to apply a terahertz signal to the signal path 116, or to receive a terahertz signal from the signal path 116, or both. For example, one of the two electrical circuits 201, 202 may operate in a transmission mode applying a terahertz signal to the signal path 116. The other of the two electrical circuits 201, 202 may then operate in a reception mode receiving the terahertz signal, which has propagated through the signal path 116.

The signal path 116 in its entirety may be functionally equivalent to a waveguide. In that case, also referring to FIG. 1, the channel of porous silicon 107 has substantially uniform cross-sectional dimensions over its entire length. That is, the width 114 and the depth 115 of the channel of porous silicon 107 is constant over its entire length, as well as the cross-sectional shape of the channel.

Alternatively, the signal path 116 may functionally include a passive electrical circuit such as, for example, a filter or a coupler. Namely, it is possible to functionally implement one or more reactive elements in the signal path 116 by one or more variations in cross-sectional dimensions of the channel of porous silicon 107 along its length. Thus, the channel of porous silicon 107 may comprise at least two longitudinal sections having different cross-sectional dimensions. These different longitudinal sections may then form a passive signal-processing circuit in the first exemplary integrated circuit, namely in between the two electrical circuits 201, 202.

The first exemplary integrated circuit device 200 is a basic illustration that the signal path 116 may constitute a waveguide, a transmission line, as well as a passive electrical circuit in an integrated circuit device capable of operating in the terahertz range. The illustration is basic in the sense that the signal path 116 is straight-lined and has no junctions or crossings in the first exemplary integrated circuit device 200. In more evolved embodiments, the signal path 116 may comprise one or more bends or may comprise one or more junctions, or both. A junction in the signal path 116 may be Y-shaped or T-shaped. It is also possible that the signal path 116 may comprises or one or more crossings.

FIG. 3 schematically illustrates a second exemplary integrated circuit device 300 capable of operating at a frequency in the terahertz range. FIG. 3 provides a schematic top view of the second exemplary integrated circuit device 300. The second exemplary integrated circuit device 300 may also be manufactured according to the method described hereinbefore with reference to FIG. 1, wherein the additional step 104 has been carried out. Like elements are therefore denoted by like references.

The second exemplary integrated circuit device 300 comprises an electrical circuit 301 that is coupled to the signal path 116 formed by the channel of porous silicon 107 within the low-resistivity silicon 106 as illustrated in FIG. 1. The signal path 116 comprises two different longitudinal sections 302, 303. In one longitudinal section 302, the electrically conductive structure 117 covering the channel of porous silicon 107 is nonperforated. This longitudinal section 302 is functionally equivalent to a waveguide and will therefore be referred to as the waveguide section 302. In another longitudinal section 303, the electrically conductive structure 117 covering the channel of porous silicon 107 is perforated. That is, the electrically conductive structure 117 comprises openings 304, which makes that the porous silicon 107 in this other longitudinal section 303 is exposed to an environmental condition in which the second exemplary integrated circuit device 300 is present. The other longitudinal section 303 will therefore be referred to as the exposed section 303. The signal path 116 has a signal response, which may be a default signal response when the exposed section 303 is exposed to a default environmental condition.

The exposed section 303 of the signal path 116 may functionally constitute a sensor 305. For example, molecules within the environmental condition may penetrate into the porous silicon 107. A specific type of molecule may cause a specific alteration of the signal response of the signal path 116 in the terahertz range. The presence of this specific type of molecule may be detected by detecting the specific alteration of the signal response. Moreover, the signal response may vary as a function of a concentration of the molecules of the specific type that have penetrated the porous silicon 107. The concentration of these molecules may be measured by measuring the signal response. The electric circuit 301 may be adapted to detect an alteration of a signal response of the signal path 116 and, moreover, may be adapted to measure the signal response. The electrical circuit 301 may thus detect the presence of a specific type of molecule and, moreover, may measure the concentration of these molecules. Alternatively, measurement and detection may involve at least one further electric circuit, which may be coupled to an end of the signal path 116 opposite to the electrical circuit 301, somewhat similar to what is illustrated in FIG. 2.

Several techniques may be used to enhance sensing of molecules as described hereinbefore. The openings 304 in the electrically conductive structure 117 may have a geometry that is specifically adapted to make the signal response of the signal path 116 particularly sensitive to a type of molecule of interest. For example, resonating patterns may be formed in the openings 304. Alternatively, or additionally, structures may be formed in the porous silicon 107 that resonate in response to the presence of a type of molecule of interest. Pore surfaces in the porous silicon 107 may be processed or functionalized, or both, to make the signal response particularly sensitive to a type of molecule of interest. For example, one or more substances may be applied to the pore surfaces, which may include nanoparticles. As another example, pores may be filled, at least partially, with a substance that is sensitive to a type of molecule of interest. Such a substance may be, for example, a polymer that is sensitive to a particular type of gas

The second exemplary integrated circuit device 300 is a basic illustration that the signal path 116 may constitute a sensor in an integrated circuit device capable of operating in the terahertz range. The illustration is basic in the sense that the signal path 116 has no branches in the second exemplary integrated circuit device 300. In more evolved embodiments, the signal path 116 may have several branches at least some of which comprise an exposed section similar to the exposed section 303 discussed hereinbefore. In such an embodiment, the exposed section of one of the several branches may be adapted to sense a particular type of molecule, while the exposed section of another branch may be adapted to sense another particular type of molecule. This allows multiplexed sensing: a single electrical circuit arrangement may sense different types of molecules.

FIG. 4 schematically illustrates a third exemplary integrated circuit device 400 capable of operating at a frequency in the terahertz range. FIG. 4 provides a schematic top view of the third exemplary integrated circuit device 400. The third exemplary integrated circuit device 400 may also be manufactured according to the method described hereinbefore with reference to FIG. 1, wherein the additional step 104 has been carried out. Like elements are therefore denoted by like references.

Like the second exemplary integrated circuit device 300, the third exemplary integrated circuit device 400 comprises an electrical circuit 401 that is coupled to the signal path 116 formed by the channel of porous silicon 107 within the low-resistivity silicon 106 as illustrated in FIG. 1. The signal path 116 comprises two different longitudinal sections 402, 403. In one longitudinal section 402, the channel of porous silicon 107 is covered by the electrically conductive structure 117. This longitudinal section 402 is functionally equivalent to a waveguide and will therefore be referred to as the waveguide section 402. In another longitudinal section 403, the channel of porous silicon 107 is covered by a layout of electrically conductive elements 404, which may differ in shape and geometry. The layout of electrically conductive elements 404 may be in the form of an assembly of electrically conductive patches, which are arranged in a certain pattern on top of the porous silicon 107. The other longitudinal section 403 of the signal path 116 where this layout 404 is present will be referred to hereinafter as the patch-covered section 403 for ease of reading.

The patch-covered section 403 of the signal path 116 may functionally constitute an antenna 405. Namely, the layout of electrically conductive elements 404 may constitute a so-called meta-surface that induces a well-defined outward leakage of a terahertz signal in the signal path 116. The electrical circuit 401, which is coupled to the patch-covered section 403 through the waveguide section 402, may functionally constitute a receiver or a transmitter, or a combination of both, that is, a transceiver.

The third exemplary integrated circuit device 400 is a basic illustration that the signal path 116 may functionally constitute an antenna in an integrated circuit device capable of operating in the terahertz range. The illustration is again basic in the sense that the signal path 116 has no branches in the third exemplary integrated circuit device 400. In more evolved embodiments, the signal path 116 may have several branches at least some of which comprise a patch covered as discussed hereinbefore. This allows implementing, for example, an antenna array.

It should be noted that a patch-covered section 403 in the signal path 116 formed by the channel of porous silicon 107 may have a different function. The patch-covered section 403 may form at least one reactive element in the signal path 116, that is, may functionally implement at least one reactive element. For example, the signal path 116 in the first exemplary integrated circuit device 200 illustrated in FIG. 2 may be modified as follows. Over a longitudinal section of the signal path 116, the electrically conductive structure 117 is replaced by a layout of electrically conductive elements, which may differ in shape and geometry, similar to the layout of electrically conductive elements 404 represented in FIG. 4. This longitudinal section may then form a passive electrical circuit between the two electrical circuits 201, 202.

A practical embodiment of an integrated circuit device capable of operating at a frequency in the terahertz range may comprise various signal paths. Any of these may correspond to the signal path 116 in any one of the exemplary integrated circuit devices 200, 300, 400 described hereinbefore with reference to FIGS. 2-4. That is, a practical embodiment may comprise at least one signal path that in its entirety is functionally equivalent to a waveguide, at least one other signal path having an exposed zone that functionally constitutes a sensor, at least one yet other signal path comprising a patch-covered section that is functionally equivalent to an antenna, as well as at least one yet other signal path that functionally implements a passive electrical circuit. A practical embodiment may also comprise a subset of the signal paths mentioned hereinbefore.

Accordingly, there are numerous different applications in which practical embodiments may be used to advantage. For example, a practical embodiment for a communication application may comprise one or more signal paths comprising a patch-covered section that is functionally equivalent to an antenna. The same applies to the practical embodiment for a radar detection application or a radar imaging application. Such an application may concern, for example, detection of dangerous objects, such as weapons, analysis of materials, including nano materials, or medical analysis involving imaging a living body. A practical embodiment for a chemical analysis application may comprise one or more signal paths comprising an exposed section that is functionally equivalent to a sensor. Such a practical embodiment may be used for, for example, monitoring air quality, detecting dangerous substances including explosives, and detecting biological substances molecules.

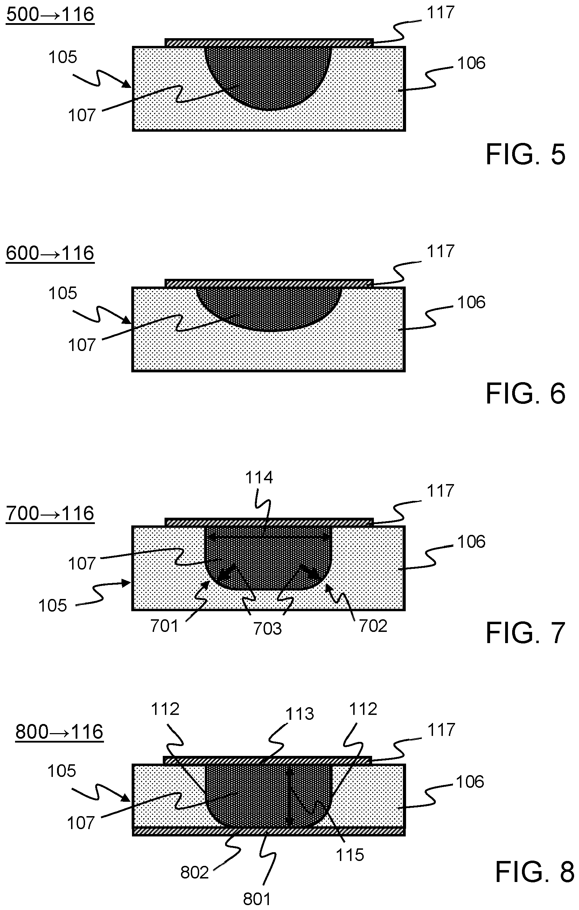

FIGS. 5-8 schematically illustrate various exemplary embodiments of the signal path 116 that functionally implements a waveguide in the first exemplary integrated circuit device 200. FIGS. 5-8 each provide a schematic cross-sectional view of a specific exemplary embodiment. The aforementioned waveguide sections 302, 402 in the second and third exemplary integrated circuit devices 300, 400 may be embodied similarly. Since the various exemplary embodiments may be manufactured in accordance with the method illustrated in FIG. 1, like elements are denoted by like references.

FIG. 5 schematically illustrates a first exemplary embodiment 500. In this embodiment 500, the channel of porous silicon 107 has a cross-sectional shape that is substantially half circular. This cross-sectional shape may be obtained by an appropriate setting of one or more process parameters in the electrochemical treatment step 102 discussed hereinbefore with reference to FIG. 1. These process parameters may include, for example, a composition of the chemically reactive substance 110, an intensity of the electrical current 111 flowing from the substrate 105 into the chemically reactive substance 110, as well as an intensity distribution of this electrical current 111.

FIG. 6 schematically illustrates a second exemplary embodiment 600. In this embodiment 600, the channel of porous silicon 107 has a cross-sectional shape that is substantially half elliptical. This cross-sectional shape may be obtained by an appropriate setting of one or more process parameters in the electrochemical treatment step 102, as discussed hereinbefore regarding the first exemplary embodiment 500 illustrated in FIG. 5.

FIG. 7 schematically illustrates a third exemplary embodiment 700. In this embodiment 700, the channel of porous silicon 107 has a cross-sectional shape that is substantially rectangular with rounded corners 701, 702 within the silicon substrate 105. Again, this cross-sectional shape may be obtained by an appropriate setting of one or more process parameters in the electrochemical treatment step 102, as discussed hereinbefore regarding the first exemplary embodiment 500 illustrated in FIG. 5. The rounded corners 701, 702 may each have a radius 703 between one tenth and one third of the width 114 of the channel of porous silicon 107, which corresponds to a width of the rectangular cross-sectional shape.

In a specific application, one among the three exemplary embodiments 500, 600, 700 presented hereinbefore with reference to FIGS. 5-7 may better meet requirements than the other two embodiments. It is also possible that another embodiment having a cross-sectional shape different from those discussed hereinbefore better meets requirements than the three exemplary embodiments 500, 600, 700 presented hereinbefore. In each embodiment, characterized by a specific cross-sectional shape, there may be an optimum for the width 114 and the depth 115 of the channel at which requirements are best met.

FIG. 8 schematically illustrates a fourth exemplary embodiment 800. In this embodiment 800, the channel of porous silicon 107 extends from the top surface of the substrate 105 to the bottom surface of the substrate 105. That is, the depth 115 of the channel of porous silicon 107 corresponds to a thickness of the substrate 105 where the channel has been formed. In this embodiment, the bottom surface of the substrate 105 is provided with an electrically conductive layer 801. To that end, the manufacturing method 100 described hereinbefore with reference to FIG. 1 may comprise a further processing step in which the electrically conductive layer 801 is deposited on the bottom surface of the substrate 105. Alternatively, the substrate 105 may be bonded to an electrically conductive substrate, which may be of metal, forming the electrically conductive layer 801.

In the fourth exemplary embodiment 800, the channel of porous silicon 107 thus includes a bottom interfacing surface 802 where the porous silicon 107 interfaces with the electrically conductive layer 801 on the bottom surface of the substrate 105. The bottom interfacing surface 802, the top interfacing surface 113, and the embedded interfacing surface 112 then jointly confine a terahertz signal in the signal path 116 formed by the channel of porous silicon 107. The electrically conductive layer 801 need not be uniform. For example, the electrically conductive layer 801 may comprise a zone with one or more openings therein, similar to the openings 304 in the electrically conductive structure 117, schematically represented in FIG. 3. This zone may functionally constitute a sensor. As another example, the electrically conductive layer 801 may comprise a zone with cutouts forming a layout of electrically conductive elements, similar to the layout of electrically conductive elements 404, schematically represented in FIG. 4. This zone may functionally constitute antenna.

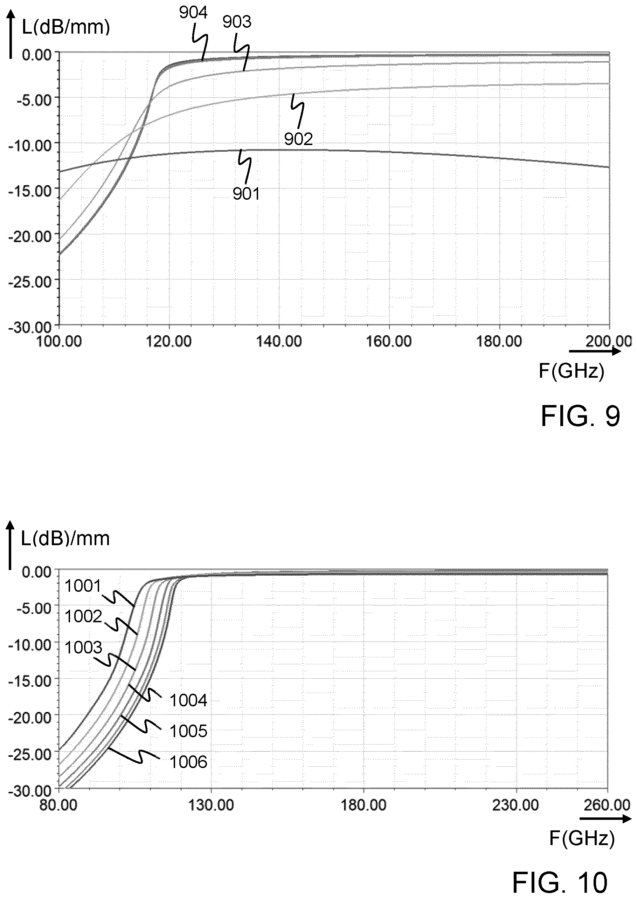

FIG. 9 illustrates signal loss in the first exemplary embodiment 500 illustrated in FIG. 5 varying as a function of signal frequency for different resistivities that the low-resistivity silicon 106 may have. FIG. 9 provides a graph having a horizontal axis that represents the signal frequency expressed in units of gigahertz (GHz) and a vertical axis that represents the signal loss expressed in in units of decibel per mm (dB/mm). The graph comprises four curves 901-904, each representing the signal loss varying as a function of the signal frequency for a specific resistivity that the low-resistivity silicon 106 may have. A first curve 901 is obtained when the resistivity of the low-resistivity silicon 106 is 1 Ohm.cm, a second curve 902 when the resistivity is 0.1 Ohm.cm, a third curve 903 when the resistivity is 0.01 Ohm.cm, and a fourth curve 904 when the resistivity is 0.001 Ohm.cm. The porous silicon 107 has a resistivity of about 10 kOhm.cm. The graph of FIG. 9 was obtained by computer simulation using a program dedicated to the analysis of electromagnetic structures, hence including waveguides.

The graph of FIG. 9 illustrates that the lower the resistivity of the low-resistivity silicon 106 is, the lower the signal loss is. This may be explained by a terahertz signal being more strongly confined in the signal path 116 as the resistivity of the low-resistivity silicon 106 decreases. This may be related to there being a greater change in resistivity at the embedded interfacing surface 112 if the resistivity of the low-resistivity silicon 106 decreases. That is, the contrast in resistivity then increases at the embedded interfacing surface 112. Notwithstanding, it is contemplated that the porous silicon 107 should have a sufficiently high resistivity to ensure that the signal loss is acceptable.

The graph of FIG. 9 illustrates that there is a cut-off frequency below which the signal loss significantly increases as the frequency decreases. This particularly applies to the third and fourth curves 903, 904 and to a certain extent also to the second curve 902. The cut-off frequency is about 120 GHz in this example. The cut-off frequency may be different depending on the geometry of the channel of porous silicon 107, as well as, to a lesser extent, on the resistivity of the porous silicon 107 and that of the relatively low-resistivity silicon 106.

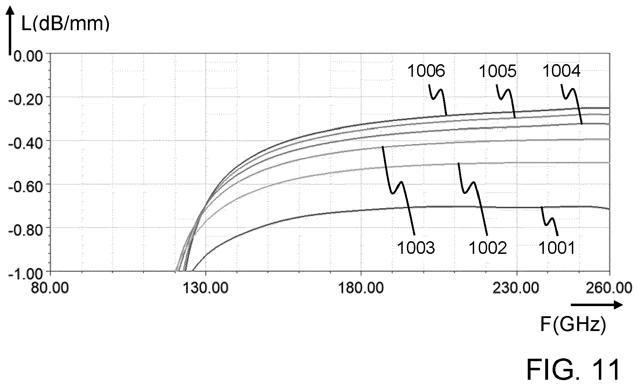

FIGS. 10 and 11 illustrate signal loss in the third exemplary embodiment 700 illustrated in FIG. 7 varying as a function of signal frequency for different radiuses 703 of the rounded corners 701, 702 this embodiment may have within the semiconductor substrate 105. FIGS. 10 and 11 each provide a graph having a horizontal axis that represents the signal frequency expressed in units of gigahertz (GHz) and a vertical axis that represents the signal loss expressed in in units of decibel per mm (dB/mm). The graph of FIG. 11 is a vertically enlarged slice from the graph of FIG. 10 representing the signal loss on a finer scale, namely in a range between 0.0 and -1.0 dB/mm.

The graphs of FIGS. 10 and 11 each comprise six curves 1001-1006, each representing the signal loss varying as a function of the signal frequency for a specific radius 703 of the rounded corners 701, 702 that the first exemplary integrated waveguide may have within the semiconductor substrate 105. A first curve 1001 is obtained when the radius 703 of the rounded corners 701, 702 is 100 µm, a second curve 1002 when the radius 703 of the rounded corners 701, 702 is 150 µm, a third curve 1003 when the radius 703 of the rounded corners 701, 702 is 200 µm, a fourth curve 1004 when the radius 703 of the rounded corners 701, 702 is 250 µm, a fifth curve 1005 when the radius 703 of the rounded corners 701, 702 is 300 µm, and a sixth curve 1006 when the radius 703 of the rounded corners 701, 702 is 350 µm. The low-resistivity silicon has a resistivity of about 0.001 Ohm.cm. The porous silicon 107 has a resistivity of about 10 kOhm.cm. The graphs of FIGS. 10 and 11 were obtained by computer simulation using a program dedicated to the analysis of electromagnetic structures, hence including waveguides

Like the graph of FIG. 9, the graphs of FIGS. 10 and 11 also illustrate that that there is a cut-off frequency below which the signal loss significantly increases as the frequency decreases, which is typical for waveguides. Also referring to FIG. 7, the smaller the radius 703 of the rounded corners 701, 702 is, the lower the cut-off frequency is. The cut-off frequency is about 105 GHz in case the radius 703 is 100 µm. The cut-off frequency is about 118 GHz in case the radius 703 is 350 µm. Above the cut-off frequency, it holds that the larger the radius 703 of the rounded corners 701, 702 is, the lower the signal loss is. This is particularly visible in FIG. 11.

### NOTES

The embodiments described hereinbefore with reference to the drawings are presented by way of illustration. The invention may be implemented in numerous different ways. In order to illustrate this, some alternatives are briefly indicated.

The invention may be applied in numerous types of products or methods related to circuits capable of operating in the terahertz range. In the presented embodiments, the substrate comprises silicon as semiconductor material. In other embodiments, the substrate may comprise another semiconductor material, such as, for example, gallium arsenide or gallium nitride. The term integrated circuit device should be interpreted broadly. This term encompasses any type of semiconductor circuit arrangement capable of operating in the terahertz range.

There are numerous different ways of implementing a substrate comprising low-resistivity semiconductor material. For example, the substrate may entirely be formed of low-resistivity semiconductor material. Alternatively, the substrate may comprise one or more zones of low-resistivity semiconductor material, whereas other zones may comprise semiconductor material of higher resistivity. A zone of low-resistivity semiconductor material may be formed, for example, by relatively heavily doping the zone with a suitable dopant or combination of dopants. A method in accordance with the invention may thus comprise a doping step in which one or more zones of low-resistivity semiconductor material are formed in a substrate, after which a channel of porous silicon may be formed in such a zone. Such a method may comprise the steps of the manufacturing method described with reference to FIG. 1, whereby the aforementioned doping step precedes these steps.

The remarks made hereinbefore demonstrate that the embodiments described with reference to the drawings illustrate the invention, rather than limit the invention. The invention can be implemented in numerous alternative ways that are within the scope of the appended claims. All changes that come within the meaning and range of equivalency of the claims are to be embraced within their scope. Any reference sign in a claim should not be construed as limiting the claim. The verb "comprise" in a claim does not exclude the presence of other elements or other steps than those listed in the claim. The same applies to similar verbs such as "include" and "contain". The mention of an element in singular in a claim pertaining to a product, does not exclude that the product may comprise a plurality of such elements. Likewise, the mention of a step in singular in a claim pertaining to a method does not exclude that the method may comprise a plurality of such steps. The mere fact that respective dependent claims define respective additional features, does not exclude combinations of additional features other than those reflected in the claims.

## Claims

1. An integrated circuit device (200, 300, 400) capable of operating at a frequency in a range between 0.1 THz and 10 THz, the integrated circuit device comprising:
- a substrate (105) comprising low-resistivity semiconductor material (106), the low-resistivity semiconductor material having a resistivity that is nominally lower than 0.1 Ohm.cm; and
- a channel of porous semiconductor material (107) comprised in the low-resistivity semiconductor material, the porous semiconductor material having a resistivity that is higher than 100 Ohm.cm, the channel of porous semiconductor material constituting a signal path (116) within the integrated circuit device for a signal having a frequency in the range between 0.1 THz and 10 THz.

2. An integrated circuit device according to claim 1, wherein at least a longitudinal section (302, 402) of the channel of porous semiconductor material (107) is covered by an electrically conductive structure (117).

3. An integrated circuit device according to claim 2, wherein the electrically conductive structure (117) comprises a metal layer on the semiconductor substrate.

4. An integrated circuit device according to any of claims 1 to 3, wherein the channel of porous semiconductor material (107) has a width (114) between 10 µm and 2 mm.

5. An integrated circuit device according to any of claims 1 to 4, wherein the channel of porous semiconductor material (107) has a depth (115) between 5 µm and 500 µm.

6. An integrated circuit device according to any of claims 1 to 5, wherein the channel of porous semiconductor material (107) has a cross-sectional shape having at least one curved portion.

7. An integrated circuit device according to claim 6, wherein the cross-sectional shape corresponds to one of the following shapes: half circular, half elliptical, and rectangular with rounded corners (701, 702) within the semiconductor substrate.

8. An integrated circuit device according to any of claims 1 to 7, wherein the channel of porous semiconductor material (107) has uniform cross-sectional dimensions thereby forming a waveguide in the integrated circuit device.

9. An integrated circuit device according to any of claims 1 to 7, wherein the channel of porous semiconductor material (107) comprises at least two longitudinal sections having different cross-sectional dimensions thereby forming a passive signal-processing circuit in the integrated circuit.

10. An integrated circuit device according to any of claims 1 to 7, wherein the channel of porous semiconductor material (107) comprises a section (303) that is exposed to an environmental condition in which the integrated circuit device is present thereby forming a sensor (305).

11. An integrated circuit device according to claim 10, wherein the section (303) of the channel of porous semiconductor material (107) that is exposed to the environmental condition comprises pores at least partially containing an added substance that is sensitive to a feature of the environmental condition.

12. An integrated circuit device according to any of claims 1 to 7, wherein the channel of porous semiconductor material (107) comprises a section (403) covered by a layout of electrically conductive elements (404) thereby forming an antenna (405).

13. An integrated circuit device according to any of claims 1 to 7, wherein the channel of porous semiconductor material (107) comprises a section covered by a layout of electrically conductive elements thereby forming at least one reactive element in the signal path (116).

14. A method (100) of manufacturing an integrated circuit device (200, 300, 400) capable of operating at a frequency in a range between 0.1 THz and 10 THz, the method comprising:
- providing a substrate (105) comprising low-resistivity semiconductor material (106), the low-resistivity semiconductor material having a resistivity that is nominally lower than 0.1 Ohm.cm; and
- making (101, 102) the low-resistivity semiconductor material locally porous to form a channel of porous semiconductor material (107) that is comprised in the low-resistivity semiconductor material, wherein the low-resistivity semiconductor material is locally made porous to an extent that the porous semiconductor material has a resistivity that is higher than 100 Ohm.cm , the channel of porous semiconductor material (107) constituting a signal path (116) within the integrated circuit device for a signal having a frequency in the range between 0.1 THz and 10 THz.

15. A method according to claim 14, comprising:
- depositing (104) an electrically conductive structure (117) on the semiconductor substrate (105) so that the electrically conductive structure covers at least a longitudinal section of the channel of porous semiconductor material (107).
